(19) Europäisches Patentamt
European Patent Office
Office européen des brevets

(11) **EP 2 200 340 A1**

(12) **EUROPEAN PATENT APPLICATION**

(43) Date of publication:
**23.06.2010 Bulletin 2010/25**

(51) Int Cl.:
***H04R 3/04*** (2006.01)    ***H03G 9/02*** (2006.01)
***H03G 7/00*** (2006.01)

(21) Application number: **09176311.0**

(22) Date of filing: **18.11.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **09.12.2008 JP 2008313155**

(71) Applicant: **Fujitsu Limited**
**Kawasaki-shi, Kanagawa 211-8588 (JP)**

(72) Inventors:
• **Otani, Takeshi**
  **Kanagawa 211-8588 (JP)**

• **Togawa, Taro**
  **Kanagawa 211-8588 (JP)**
• **Ota, Yasuji**
  **Kanagawa 211-8588 (JP)**

(74) Representative: **HOFFMANN EITLE**
**Patent- und Rechtsanwälte**
**Arabellastrasse 4**
**81925 München (DE)**

(54) **Sound processing methods and apparatus**

(57)    A sound processing method includes transforming an input signal from a time domain to a frequency domain to produce a spectrum, detecting a peak of the spectrum, calculating a target attenuation amount based on one of the input signal and the spectrum, calculating attenuation amounts of respective frequency components of the spectrum based on the target attenuation amount and the detected peak, correcting levels of the spectrum by attenuating the spectrum in response to the calculated attenuation amounts of respective frequency components, and performing inverse frequency transform with respect to the level-corrected spectrum to produce an output signal.

FIG.10

EP 2 200 340 A1

**Description**

FIELD

The disclosures herein generally relate to sound processing methods, and particularly relate to a sound processing method for compressing the dynamic range of an input signal.

BACKGROUND

When a speaker embedded in a portable terminal or the like produces big sounds, it is preferable to increase the volume of the sounds while suppressing the distortion of the sounds caused by clipping. To this end, a dynamic range compression technology has been studied.

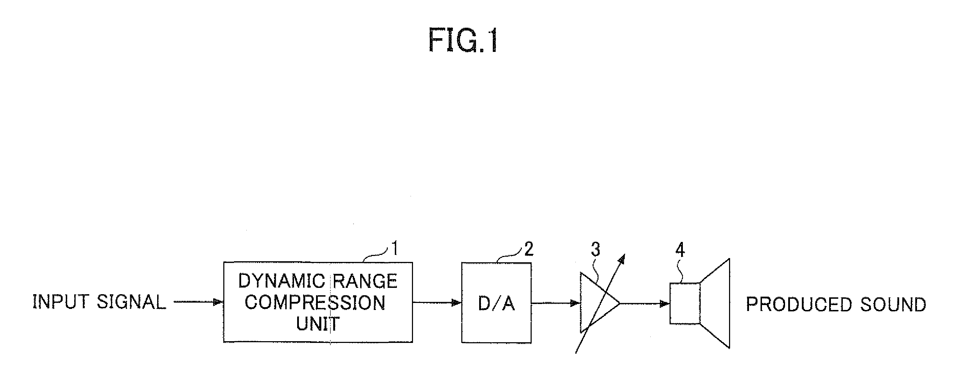

The dynamic range compression technology reduces the amplitude range of an input signal. Fig. 1 is a drawing illustrating an example of dynamic range compression used in a related-art system. As illustrated in Fig. 1, a dynamic range compression unit 1 compresses the dynamic range of an input signal. A DA converter 2 then converts the digital audio signal into an analog audio signal. An amplifier 3 amplifies the analog audio signal for the purpose of driving a speaker 4. The speaker 4 receives the analog audio signal amplified by the amplifier 3 and produces sounds.

Non-Patent Document 1 discloses an example of such a dynamic range compression technology. The disclosed technology measures the level of an input signal, and attenuates large input level portions while amplifying small input level portions.

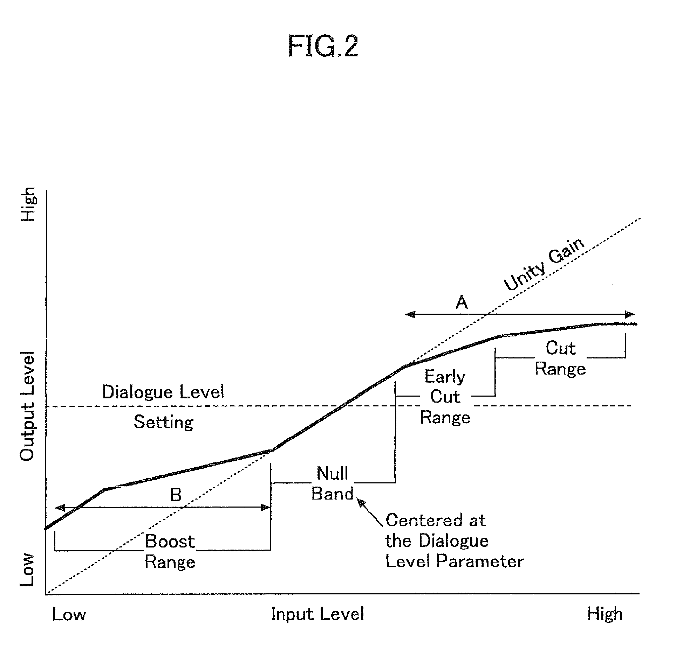

Fig. 2 is a drawing illustrating an example of related-art dynamic range compression disclosed in Non-Patent Document 1. In the example illustrated in Fig. 2, a portion A having a large volume is attenuated while a portion B having a small volume is amplified, thereby compressing the dynamic range of an input signal based on gain control. This makes it possible to increase the volume of output sounds while suppressing sound distortion caused by clipping.

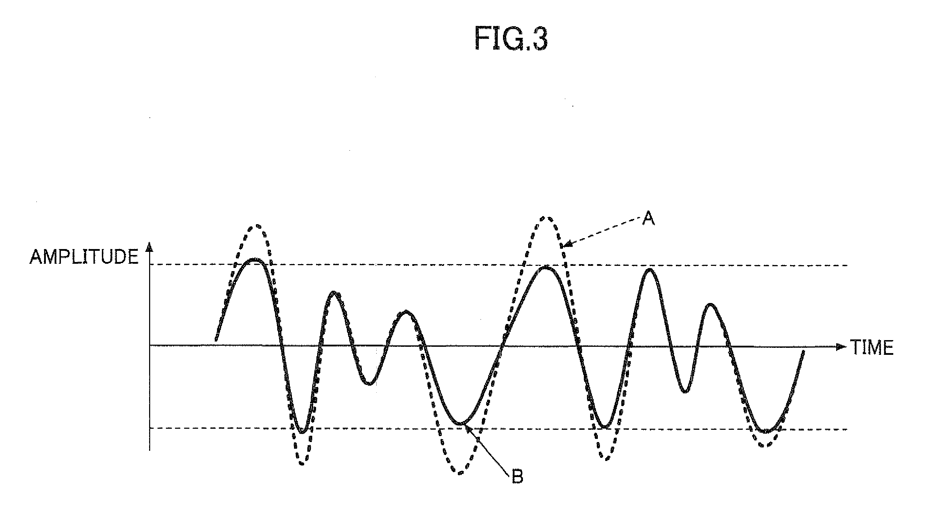

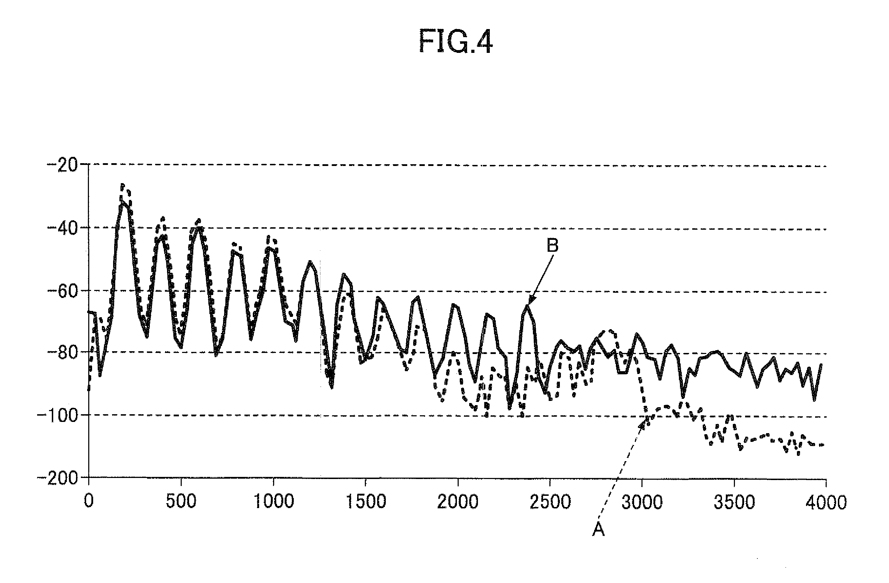

Sound distortion caused by clipping may be suppressed by multiplying an input signal by the gain obtained by the related-art technology. Since signal waveforms are modified in the time domain, however, such a modification affects the spectrum in the entire frequency domain, resulting in a poor sound quality. In the following, the above-noted problem will be described by referring to Fig. 3 and Fig. 4. Fig. 3 is a drawing illustrating an example of time-domain signal waveforms before and after the gain control performed by the related-art technology. As illustrated in Fig. 3, the time-domain signal B after the gain control has a narrower amplitude range than the time-domain signal A before the gain control.

Fig. 4 is a drawing illustrating an example of spectrum profiles before and after the gain control performed by the related-art technology. As illustrated in Fig. 4, the power spectrum B after the gain control has frequency components thereof amplified in a high-frequency range compared with the power spectrum A before the gain control. This amplified frequency range may be perceived as dissonant sounds upon reproducing audio sounds, thereby contributing to degradation in audio quality.

Accordingly, it may be preferable to provide a sound processing method that can compress a dynamic range while avoiding audio quality degradation.

[Non-Patent Document 1] "Dolby Digital Encoding Technique Section 2 'Dynamic Range Compression'", URL:http://www.dolby.co.jp/professional/studio/dvd_a uth.oring03.html

SUMMARY

According to an aspect of the embodiment, a sound processing method includes transforming an input signal from a time domain to a frequency domain to produce a spectrum, detecting a peak of the spectrum, calculating a target attenuation amount based on one of the input signal and the spectrum, calculating attenuation amounts of respective frequency components of the spectrum based on the target attenuation amount and the detected peak, correcting levels of the spectrum by attenuating the spectrum in response to the calculated attenuation amounts of respective frequency components, and performing inverse frequency transform with respect to the level-corrected spectrum to produce an output signal.

BRIEF DESCRIPTION OF DRAWINGS

Fig. 1 is a drawing illustrating an example of dynamic range compression used in a related-art system;
Fig. 2 is a drawing illustrating an example of dynamic range compression used in a related-art system;
Fig. 3 is a drawing illustrating an example of time-domain signal waveforms before and after gain control performed by the related-art technology;

Fig. 4 is a drawing illustrating an example of spectrum profiles before and after the gain control performed by the related-art technology;

Fig. 5 is a drawing illustrating an example of the configuration of a sound processing apparatus according to a first embodiment;

Fig. 6 is a drawing illustrating an example of the configuration of the dynamic range compressing unit according to the first embodiment;

Fig. 7 is a drawing illustrating the relationship between a power spectrum and attenuation amounts;

Fig. 8 is a drawing illustrating the relationship between an input spectrum and a level-corrected spectrum according to the first embodiment;

Fig. 9 is a drawing illustrating the gains of respective frequencies illustrated in Fig. 8;

Fig. 10 is a drawing illustrating an example of sound processing according to the first embodiment;

Fig. 11 is a flowchart illustrating the gain calculating process according to the first embodiment;

Fig. 12 is a drawing illustrating an example of the configuration of a sound processing apparatus according to a second embodiment;

Fig. 13 is a drawing illustrating the attenuation amounts of respective frequency components according to the second embodiment;

Fig. 14 is a drawing illustrating the relationship between an input spectrum and a level-corrected spectrum according to the second embodiment;

Fig. 15 is a drawing illustrating the gains of respective frequencies illustrated in Fig. 14;

Fig. 16 is a flowchart illustrating an example of the gain calculating process according to the second embodiment;

Fig. 17 is a drawing illustrating the relationship between an input spectrum and a level-corrected spectrum according to a third embodiment;

Fig. 18 is a drawing illustrating the gains of respective frequencies illustrated in Fig. 17;

Fig. 19 is a flowchart illustrating an example of the gain calculating process according to the third embodiment;

Fig. 20 is a drawing illustrating an example of the configuration of the dynamic range compressing unit according to the fourth embodiment;

Fig. 21 is a drawing illustrating an example of sound processing according to the fourth embodiment; and

Fig. 22 is a drawing illustrating a variation of the application of disclosed sound processing.

DESCRIPTION OF EMBODIMENTS

In the following, embodiments for carrying out the present invention will be described by referring to the accompanying drawings.

[First Embodiment]

<Main Configuration>

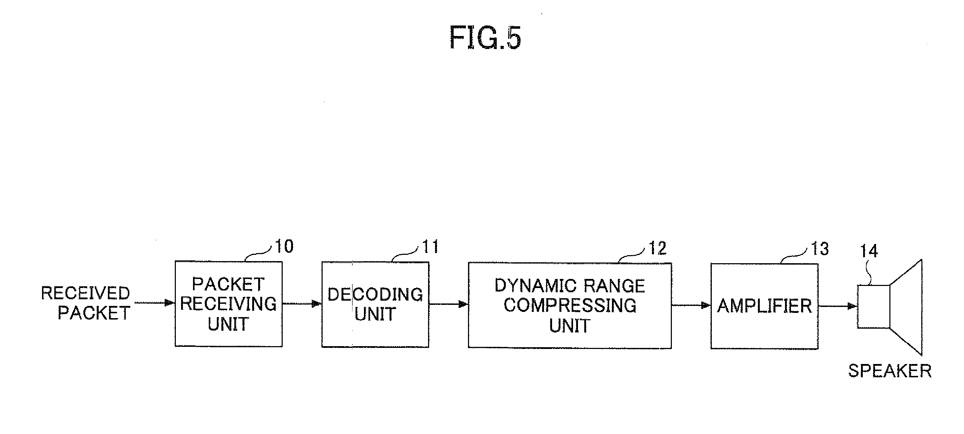

Fig. 5 is a drawing illustrating an example of the configuration of a sound processing apparatus according to a first embodiment. The example illustrated in Fig. 5 is directed to application of a sound processing apparatus to an IP (Internet Protocol) telephone. The sound processing apparatus depicted in Fig. 5 includes a packet receiving unit 10, a decoding unit 11, a dynamic range compressing unit 12, an amplifier 13, and a speaker 14.

The packet receiving unit 10 receives packets containing data of an encoded audio signal through a network, and supplies the received packets to the decoding unit 11. The decoding unit 11 decodes the data contained in the packets supplied from the packet receiving unit 10, and supplies the decoded audio signal to the dynamic range compressing unit 12. The decoding unit 11 designed for use in an IP phone is widely available, and a description of the details thereof will be omitted.

The dynamic range compressing unit 12 compresses the dynamic range of the audio signal (hereinafter referred to as an "input signal") supplied from the decoding unit 11. The detail of the dynamic range compression will be described later. The dynamic range compressing unit 12 supplies the audio signal having the dynamic range thereof compressed to the amplifier 13.

The amplifier 13 amplifies the audio signal supplied from the dynamic range compressing unit 12 for the purpose of driving the speaker 14. The amplifier 13 supplies the amplified audio signal to the speaker 14. The speaker 14 produces sounds in response to the audio signal supplied from the amplifier 13.

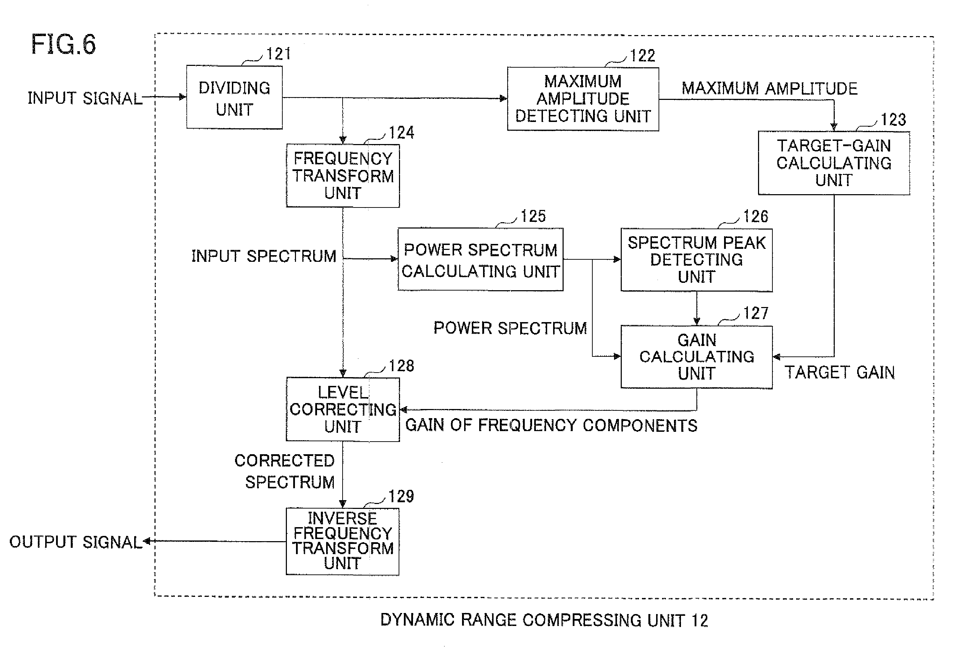

In the following, the dynamic range compressing unit 12 will be described in detail by referring to Fig. 6. Fig. 6 is a drawing illustrating an example of the configuration of the dynamic range compressing unit 12 according to the first embodiment. The dynamic range compressing unit 12 depicted in Fig. 6 includes a dividing unit 121, a maximum amplitude detecting unit 122, a target-gain calculating unit 123, a frequency transform unit 124, a power spectrum calculating unit 125, a spectrum peak detecting unit 126, a gain calculating unit 127, a level correcting unit 128, and an inverse frequency transform unit 129.

The dividing unit 121 divides the received input signal into frames having a constant time length. The divided frames are supplied from the dividing unit 121 to the maximum amplitude detecting unit 122 and to the frequency transform unit 124.

The maximum amplitude detecting unit 122 detects the maximum amplitude value of the input signal within a frame of interest supplied from the dividing unit 121 by using formula (1) as follows.

$$Pmax = max(|x(n)|) \qquad (1)$$

Here, Pmax is the maximum amplitude value within the frame of interest, and $x(n)$ is the input signal within the frame. The maximum amplitude detecting unit 122 supplies the detected maximum amplitude value Pmax to the target-gain calculating unit 123.

The target-gain calculating unit 123 calculates a target attenuation amount (i.e., target gain value) based on the maximum amplitude value supplied from the maximum amplitude detecting unit 122 by using conditional expression (2) as follows. In the following, an attenuation amount will be referred to in units of decibels (dB).

$$\begin{aligned} &if(Pmax > THR1) \\ &\qquad G\_target = Pmax - THR1 \\ &else \\ &\qquad G\_target = 0 \qquad\qquad\qquad (2) \end{aligned}$$

Here, G_target is a target attenuation amount, and THR1 is a first threshold value. The first threshold value is determined in advance in response to the characteristics of the speaker. The target-gain calculating unit 123 supplies the calculated target attenuation amount to the gain calculating unit 127.

The frequency transform unit 124 converts the input signal from the time domain to the frequency domain on a frame-by-frame basis. The time-to-frequency transform may be performed by a transform scheme such as a discrete Fourier transform (DFT) or a fast Fourier transform (FFT) that converts a signal from the time domain to the frequency domain. FFT is used in the first embodiment. FFT is widely known, and a description of its details will be omitted. Hereinafter, a spectrum obtained by FFT is referred to as $X(f)$. The frequency transform unit 124 supplies the spectrum $X(f)$ obtained by the frequency transform to the power spectrum calculating unit 125 and the level correcting unit 128 as an input spectrum.

The power spectrum calculating unit 125 calculates a power spectrum from the input spectrum supplied from the frequency transform unit 124 by using formula (3) as follows.

$$Amp(f) = 10\log_{10}(|X(f)|^2) \qquad (3)$$

Here, $Amp(f)$ is a power spectrum, which is represented as a log power spectrum. The power spectrum calculating unit 125 supplies the calculated power spectrum to the spectrum peak detecting unit 126 and to the gain calculating unit 127.

The spectrum peak detecting unit 126 detects a power spectrum peak value (hereinafter simply referred to as a "power value") based on the power spectrum supplied from the power spectrum calculating unit 125 by using formula (4) as follows. The spectrum peak detecting unit 126 further detects the frequency of the power spectrum peak based on the power spectrum by using formula (5) as follows.

$$Amp\_peak = max(Amp(f)) \qquad (4)$$

$$f\_peak = argmax(Amp(f)) \qquad (5)$$

Here, Amp_peak is a power spectrum peak value (i.e., the value of the peak of the power spectrum), and f_peak is the frequency of the peak of the power spectrum. The spectrum peak detecting unit 126 supplies the power value of the spectrum peak (i.e., power spectrum peak value) obtained by formula (4) and the frequency obtained by formula (5) to the gain calculating unit 127.

The gain calculating unit 127 calculates attenuation amounts (i.e., gain values) of respective frequency components by using conditional expression (6) as follows based on the power spectrum Amp(f) supplied from the power spectrum calculating unit 125, the power value Amp_peak of the spectrum peak supplied from the spectrum peak detecting unit 126, the target attenuation amount G_target supplied from the target-gain calculating unit 123, and the second threshold value.

$$
\begin{aligned}
&\text{if } (Amp(f) \geq Amp\_peak-THR2) \\
&\quad G(f)=(G\_target/THR2)(Amp(f)-(Amp\_peak-THR2)) \\
&\text{else} \\
&\quad G(f)=0 \qquad\qquad\qquad\qquad\qquad\qquad (6)
\end{aligned}
$$

Here, G(f) represents attenuation amounts of respective frequencies, and THR2 is the second threshold value. The second threshold value is determined in advance to specify a range within which the power spectrum values are attenuated.

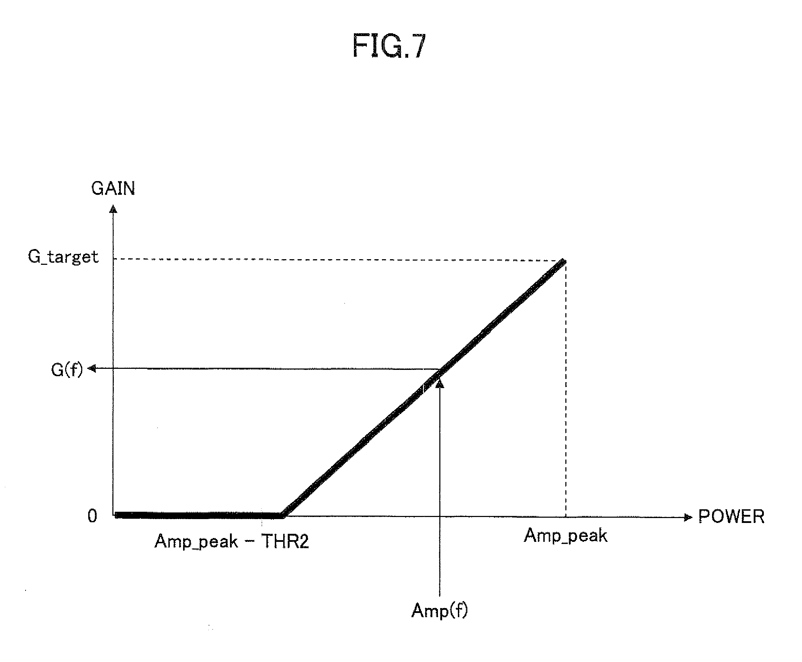

Conditional expression (6) will be described with reference to Fig. 7. Fig. 7 is a drawing illustrating the relationship between a power spectrum and attenuation amounts. Namely, Fig. 7 diagrammatically illustrates conditional expression (6). As illustrated in Fig. 7, the attenuation amount of a given frequency component decreases from the target attenuation amount in proportion to a difference between the corresponding power spectrum value and the power value of the spectrum peak.

The above-described statement holds true when the difference between the corresponding power spectrum value and the power value of the spectrum peak is smaller than or equal to the second threshold value. The attenuation amount is set to zero for a given frequency component for which the above-noted difference is larger than the second threshold value. With this arrangement, the attenuation amount of a given frequency component is determined by deriving a difference between the corresponding power spectrum value and the power value of the spectrum peak once the target attenuation amount is given.

The reason why the attenuation amount is set to zero when the difference is larger than the second threshold value is because there is no need to attenuate an input signal frequency component that is not so large from the beginning. Referring to Fig. 6 again, the gain calculating unit 127 supplies the calculated attenuation amounts G(f) of respective frequency components to the level correcting unit 128.

The level correcting unit 128 calculates a level-corrected spectrum by using formula (7) as follows based on the input spectrum supplied from the frequency transform unit 124 and the attenuation amounts of respective frequency components supplied from the gain calculating unit 127.

$$
Y(f)=X(f)e^{-G(f)/20} \qquad (7)
$$

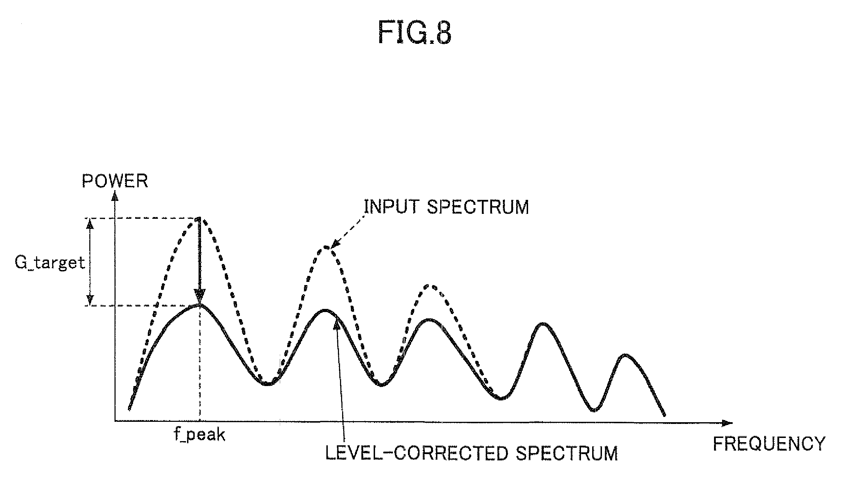

Here, Y(f) represents a level-corrected spectrum. Fig. 8 is a drawing illustrating the relationship between an input spectrum and a level-corrected spectrum according to the first embodiment. As illustrated in Fig. 8, the frequency components of the input spectrum are attenuated by the respective attenuation amounts calculated by the gain calculating unit 127, thereby producing a level-corrected spectrum.

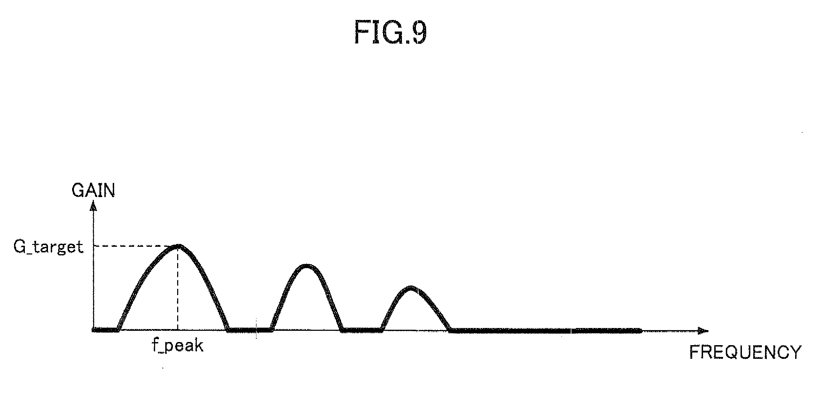

Fig. 9 is a drawing illustrating the gains of respective frequencies illustrated in Fig. 8. As illustrated in Fig. 9, gain control is performed around each spectrum peak according to the first embodiment. Referring to Fig. 6 again, the level correcting unit 128 supplies the calculated level-corrected spectrum Y(f) to the inverse frequency transform unit 129.

The inverse frequency transform unit 129 performs inverse frequency transform (e.g., IFFT) with respect to the level-corrected spectrum supplied from the level correcting unit 128. The inverse frequency transform unit 129 supplies the signal obtained by the inverse frequency transform to the amplifier 13. The speaker 14 produces sounds in response to an audio signal amplified by the amplifier 13.

<Sound Processing>

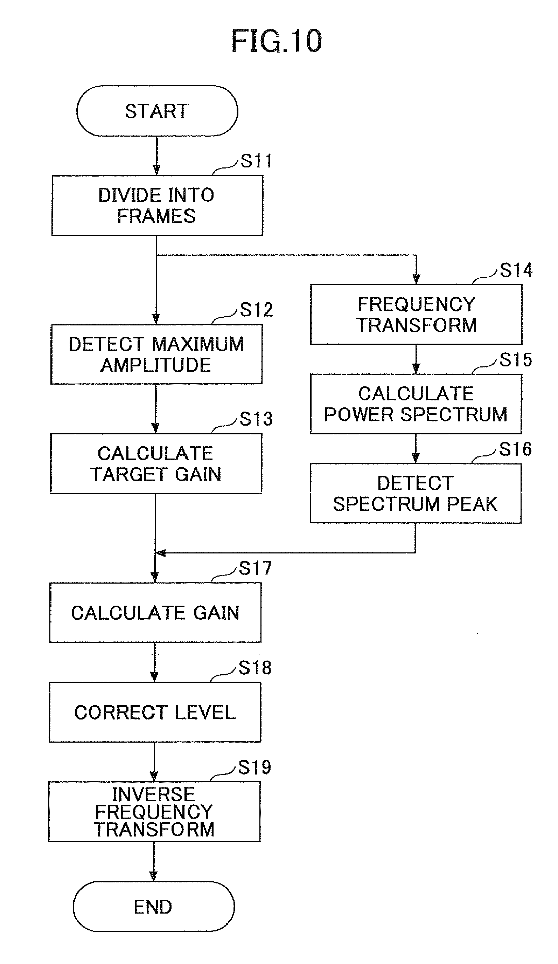

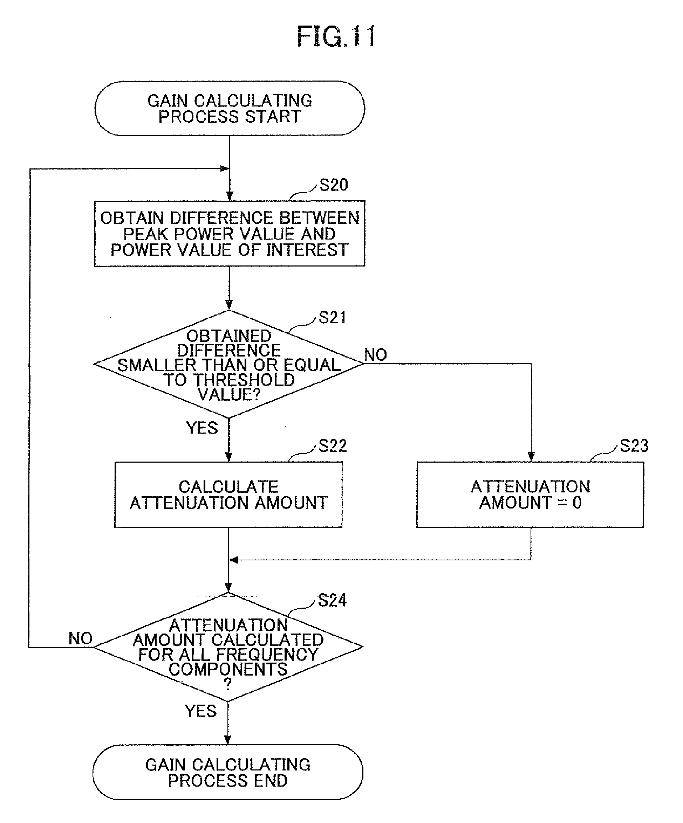

The sound processing of the first embodiment will be described with reference to Fig. 10 and Fig. 11. Fig. 10 is a drawing illustrating an example of sound processing according to the first embodiment. In step S11 the dividing unit 121 divides an input signal into frames, and supplies the divided frames to the maximum amplitude detecting unit 122 and to the frequency transform unit 124. Processes in steps S12 and S13 and processes in steps S14 through S16 may be performed in parallel. Processes on the path of step S12 will be described first.

In step S12, the maximum amplitude detecting unit 122 identifies the maximum amplitude of the input signal supplied in units of frames by using formula (1), followed by supplying the obtained maximum amplitude to the target-gain calculating unit 123. In step S13, the target-gain calculating unit 123 calculates a target attenuation amount by using formula (2) based on the supplied maximum amplitude, followed by supplying the calculated target attenuation amount to the gain calculating unit 127.

Processes on the path of step S14 will be described next. In step S14, the frequency transform unit 124 performs frequency transform with respect to the input signal supplied in units of frames, followed by supplying the obtained input spectrum to the power spectrum calculating unit 125 and the level correcting unit 128.

In step S15, the power spectrum calculating unit 125 calculates a power spectrum from the supplied input spectrum by using formula (3), followed by supplying the calculated power spectrum to the spectrum peak detecting unit 126 and the gain calculating unit 127.

In step S16, the spectrum peak detecting unit 126 identifies the power value of the spectrum peak from the supplied power spectrum by using formula (4), followed by supplying the obtained power value to the gain calculating unit 127. Further, the spectrum peak detecting unit 126 identifies the frequency of the spectrum peak by using formula (5), followed by supplying the obtained frequency to the gain calculating unit 127. The frequency of the spectrum peak may not be used, and may not be detected in the first embodiment.

In step S17, the gain calculating unit 127 calculates attenuation amounts of respective frequency components by using conditional expression (6) based on the power spectrum supplied from the power spectrum calculating unit 125, the power value of the spectrum peak supplied from the spectrum peak detecting unit 126, and the target attenuation amount supplied from the target-gain calculating unit 123. The detail of the processing performed by the gain calculating unit 127 will be described later with reference to Fig. 11. The calculated attenuation amounts of respective frequency components are supplied to the level correcting unit 128.

In step S18, the level correcting unit 128 performs level correction by attenuating the input spectrum supplied from the frequency transform unit 124 by the attenuation amounts of respective frequency components supplied from the gain calculating unit 127, followed by supplying the obtained level-corrected spectrum to the inverse frequency transform unit 129.

In step S19, the inverse frequency transform unit 129 performs inverse frequency transform with respect to the supplied level-corrected spectrum, followed by supplying the signal obtained through the inverse frequency transform to the amplifier 13.

The gain calculating process of the first embodiment will be described by referring to Fig. 11. Fig. 11 is a flowchart illustrating the gain calculating process according to the first embodiment. Processes in steps S20 through S24 illustrated in Fig. 11 are performed by the gain calculating unit 127.

In step S20, the gain calculating unit 127 calculates a difference between a power spectrum value of interest and the power value of the spectrum peak. In step S21, a check is made as to whether the difference of power values obtained in step S20 is no larger than a threshold value.

If the result of the check in step S21 is YES, the attenuation amount of a frequency component corresponding to the power spectrum value of interest used for the calculation of the difference is calculated in step S22 by using conditional expression (6) (see Fig. 7). If the result of the check in step S21 is NO, the attenuation amount of this corresponding frequency component is set to zero in step S23.

In step S24, a check is made as to whether attenuation amounts have been calculated for all the frequency components. If the check result is NO, the procedure goes back to step S20. If the check result is YES, the gain calculating process comes to an end, and the procedure proceeds to next step S18 illustrated in Fig. 10.

According to the first embodiment, spectrum peaks are attenuated in the frequency domain, thereby compressing the dynamic range of an input signal while avoiding the generation of dissonant sounds caused by spectrum amplification.

A target attenuation amount is determined for the power value of the spectrum peak. The attenuation amount of a given frequency component is then determined based on the target attenuation amount and a difference between the power value of the spectrum peak and the corresponding power spectrum value. This allows the spectrum to be attenuated around the spectrum peak while avoiding audio quality degradation.

[Second Embodiment]

<Main Configuration>

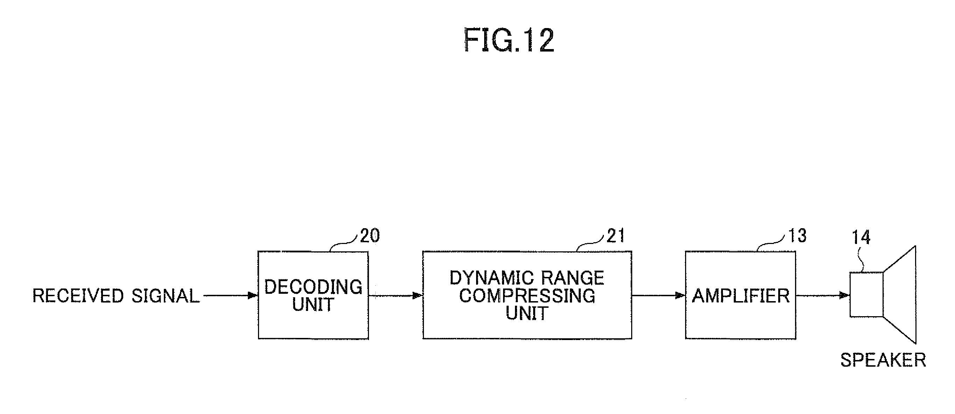

In the following, a sound processing apparatus according to a second embodiment will be described. Fig. 12 is a drawing illustrating an example of the configuration of a sound processing apparatus according to the second embodiment. The example illustrated in Fig. 12 is directed to application of a sound processing apparatus to a portable terminal. The sound processing apparatus depicted in Fig. 12 includes a decoding unit 20, a dynamic range compressing unit 21, an amplifier 13, and a speaker 14. With respect to the constituent elements illustrated in Fig. 12, the same or similar elements as those of Fig. 5 are referred to by the same numerals, and a description thereof will be omitted.

As illustrated in Fig. 12, the decoding unit 20 receives an encoded audio signal (hereinafter referred to as a "received signal") transmitted through an audio communication network, and decodes the received signal to produce an audio signal. The decoding unit 20 designed for use in a portable terminal is widely available, and a description of the details thereof will be omitted. The decoding unit 20 supplies the decoded audio signal (input signal) to the dynamic range compressing unit 21.

The dynamic range compressing unit 21 compresses the dynamic range of the input signal, followed by supplying the level-corrected audio signal to the amplifier 13. The main configuration of the dynamic range compressing unit 12 is similar to the configuration illustrated in Fig. 6, and a description thereof will be omitted. In the second embodiment, however, processing performed by the gain calculating unit 127 differs from that of the first embodiment. In the following, the processing performed by the gain calculating unit 127 will be described

The gain calculating unit 127 determines attenuation amounts of respective frequency components based on the frequency of the spectrum peak supplied from the spectrum peak detecting unit 126 and the target attenuation amount supplied from the target-gain calculating unit 123. The attenuation amounts of respective frequency components are determined by use of conditional expression (8) as follows.

```
if(0≦S(f)<f_peak-α)
    G(f)=0
elseif(f_peak-α≦S(f)<f_peak)
    G(f)=(G_target/α)(S(f)-(f_peak-α))
elseif(f_peak≦S(f)<f_peak+α)
    G(f)=(G_target/α)(S(f)-f_peak)+G_target
else
```

$$G(f)=0 \hspace{5cm} (8)$$

Here, S(f) is a difference in frequencies between the spectrum peak and each spectrum, and $\alpha$ is a threshold value. This threshold value $\alpha$ denotes a distance from the frequency of the spectrum peak to specify the frequency range in which the spectrum is attenuated.

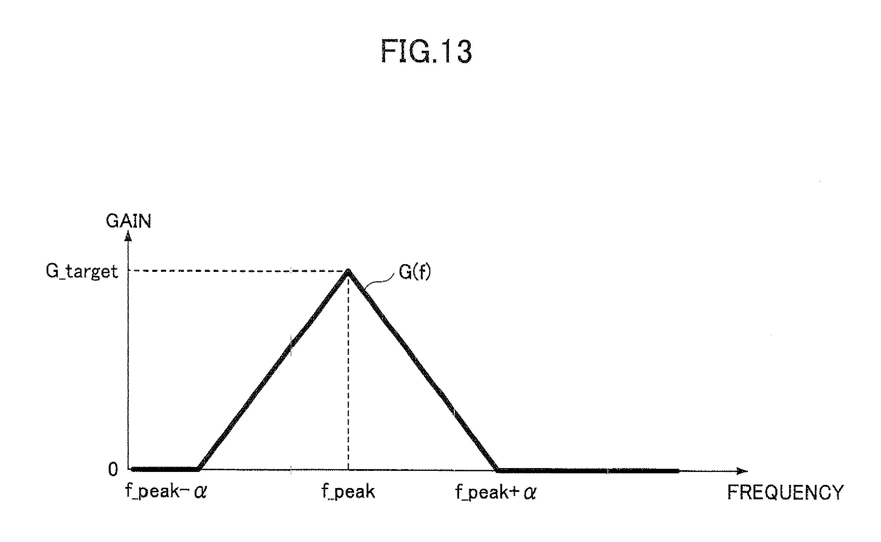

Fig. 13 is a drawing illustrating the attenuation amounts of respective frequency components according to the second embodiment. Namely, Fig. 13 diagrammatically illustrates conditional expression (8). In this manner, the spectrum is attenuated around the spectrum peak, thereby compressing the dynamic range while avoiding audio quality degradation caused by spectrum amplification.

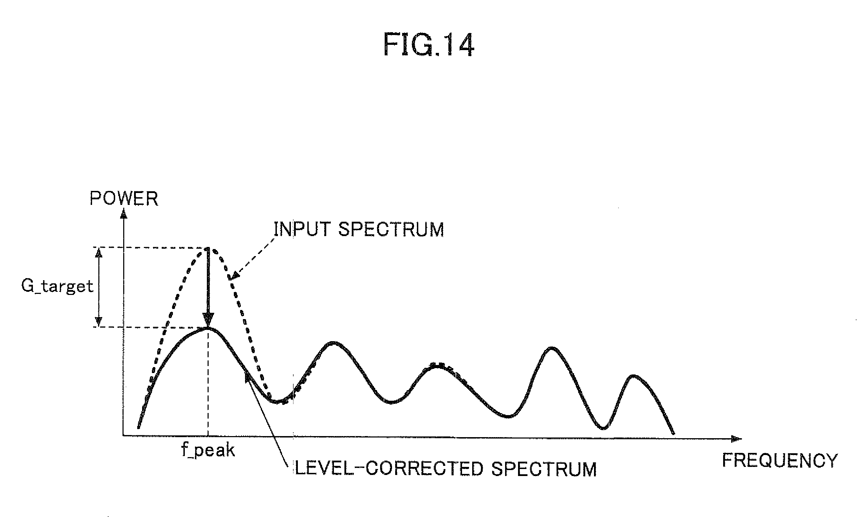

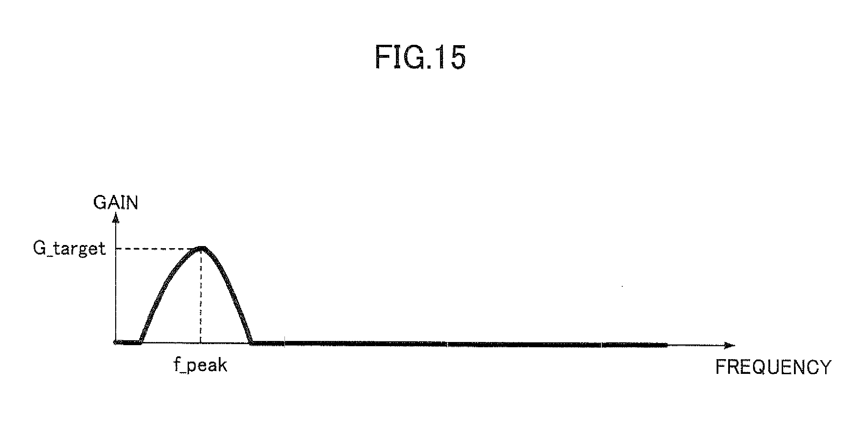

Fig. 14 is a drawing illustrating the relationship between an input spectrum and a level-corrected spectrum according to the second embodiment. As illustrated in Fig. 14, the frequency components of the input spectrum are attenuated by the respective attenuation amounts calculated by the gain calculating unit 127, thereby producing a level-corrected spectrum. Fig. 15 is a drawing illustrating the gains of respective frequencies illustrated in Fig. 14. As illustrated in Fig. 15, gain control is performed around the spectrum peak according to the second embodiment.

<Sound Processing>

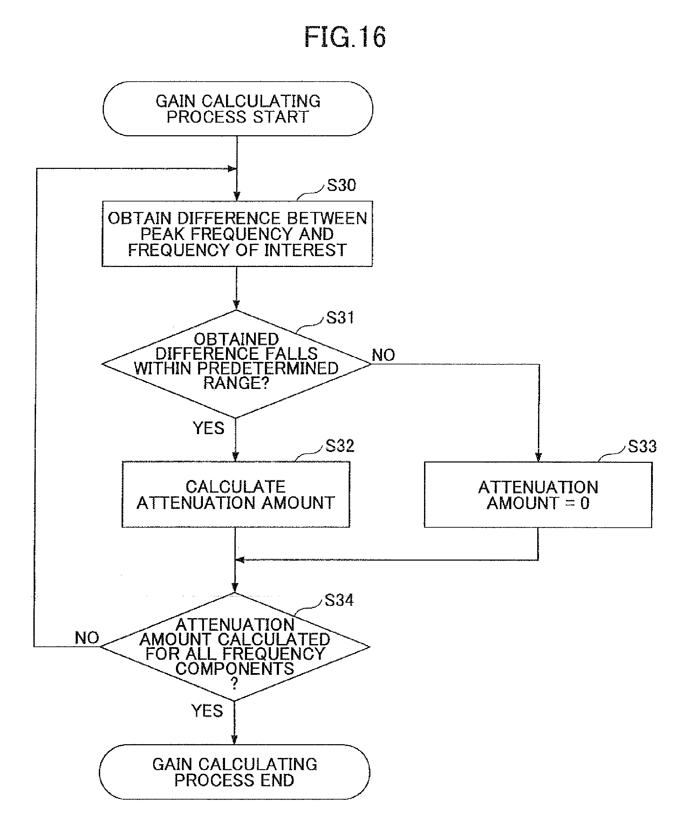

The outline of the sound processing of the second embodiment is similar to that illustrated in Fig. 10, and a description thereof will be omitted. In the following, the gain calculating process of the second embodiment will be described by referring to Fig. 16.

Fig. 16 is a flowchart illustrating an example of the gain calculating process according to the second embodiment. With respect to the steps illustrated in Fig. 16, the same or similar steps as those of Fig. 11 are referred to by the same numerals, and a description thereof will be omitted. Processes illustrated in Fig. 16 are performed by the gain calculating unit 127.

In step S30, the gain calculating unit 127 calculates a difference between the frequency of the spectrum peak and a spectrum frequency of interest. In step S31, a check is made as to whether the calculated frequency difference is within a predetermined range. In the example illustrated in Fig. 13, this predetermined range is expressed as $-\alpha \leq S(f) \leq \alpha$.

If the result of the check in step S31 is YES, the attenuation amount of the frequency component of interest is calculated in step S32 by use of conditional expression (8). If the result of the check in step S31 is NO, the attenuation amount of the frequency component of interest is set to zero in step S33.

When attenuation amounts are calculated for all the frequency components, the gain calculating process comes to an end. As a variation of the gain calculating process of the second embodiment, the process expressed by conditional expression (8) may be performed not only with respect to the vicinity of the spectrum peak but also with respect to a second spectrum peak, a third spectrum peak, and so on to calculate attenuation amounts for each of the spectrum peaks. With this arrangement, the dynamic range is efficiently compressed even when spectrum peaks such as the second and third spectrum peaks have large power values.

In the variation described above, the conditional expression (8) may not be applied as it is, but may be applied with such a modification that the G_target and $\alpha$ are reduced as the ordinal number of a spectrum peak of interest such as the second or third peak increases.

According to the second embodiment, spectrum peaks are attenuated in the frequency domain, thereby compressing the dynamic range of an input signal while avoiding the generation of dissonant sounds caused by spectrum amplification.

A target attenuation amount is determined for the power value of the spectrum peak. The attenuation amount of a given frequency component is then determined based on the target attenuation amount and a difference between the frequency of the spectrum peak and the corresponding spectrum frequency. This allows the spectrum to be attenuated around the spectrum peak while avoiding audio quality degradation.

[Third Embodiment]

<Main Configuration>

In the following, a sound processing apparatus according to a third embodiment will be described. The application field of a sound processing apparatus according to the third embodiment is similar to that of the second embodiment. The main configuration of such a sound processing apparatus is similar to the configuration illustrated in Fig. 6, and a description thereof will be omitted. In the third embodiment, however, processing performed by the gain calculating unit 127 differs from that of the first embodiment and from that of the second embodiment. In the following, the processing performed by the gain calculating unit 127 will be described

The gain calculating unit 127 calculates a target power value by use of formula (9) based on the power value Amp_peak of the spectrum peak supplied from the spectrum peak detecting unit 126 and the target attenuation amount G_target supplied from the target-gain calculating unit 123.

$$\mathrm{Amp\_target = Amp\_peak - G\_target} \qquad (9)$$

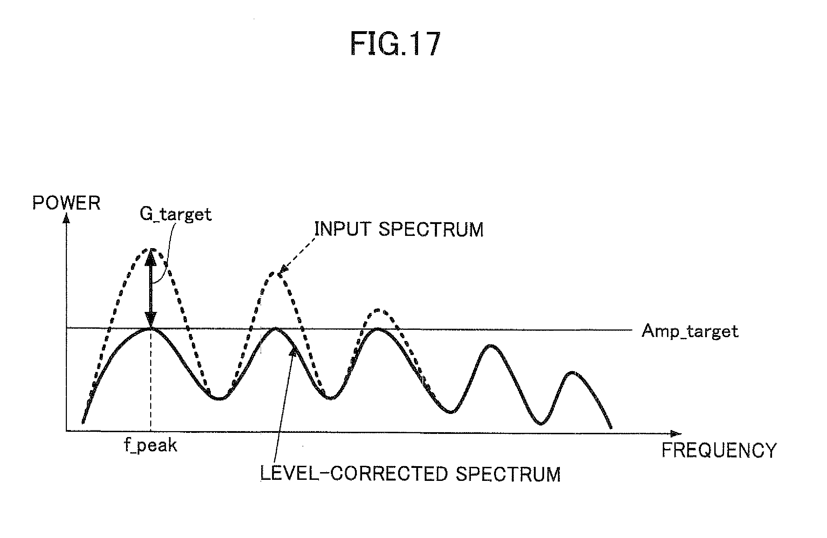

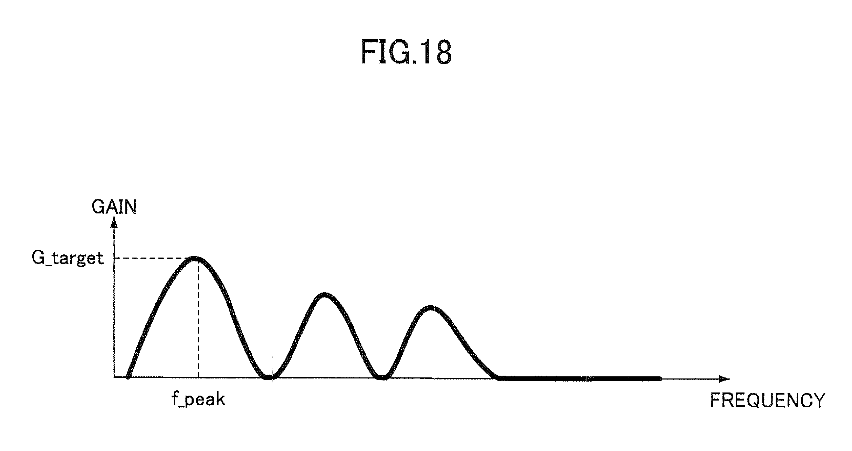

Here, Amp_target is a target power value. The gain calculating unit 127 calculate attenuation amounts of respective frequency components such that the power spectrum values of these frequency components do not exceed the target power value. Fig. 17 is a drawing illustrating the relationship between an input spectrum and a level-corrected spectrum according to the third embodiment. As illustrated in Fig. 17, the frequency components of the input spectrum are attenuated by the respective attenuation amounts calculated by the gain calculating unit 127, thereby producing a level-corrected spectrum. Fig. 18 is a drawing illustrating the gains of respective frequencies illustrated in Fig. 17. As illustrated in Fig. 18, gain control is performed around each spectrum peak that exceeds the target power value.

<Sound Processing>

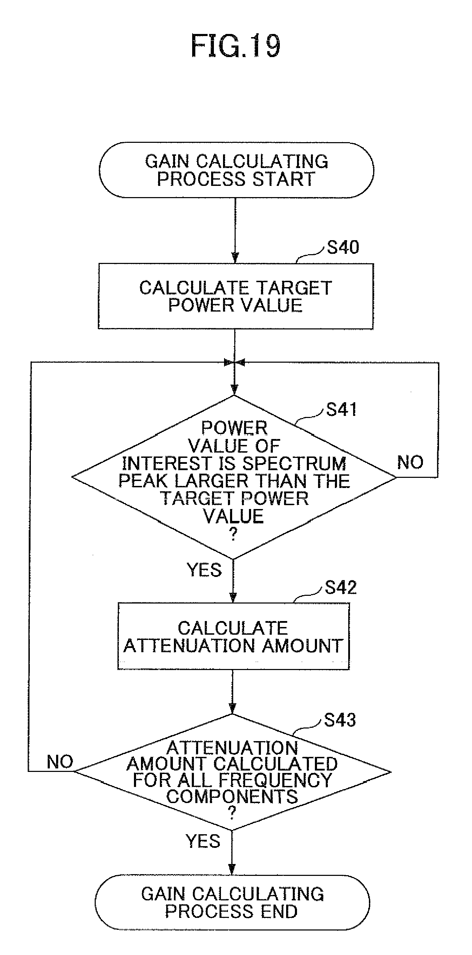

The outline of the sound processing of the second embodiment is similar to that illustrated in Fig. 10, and a description thereof will be omitted. In the following, the gain calculating process of the third embodiment will be described by referring to Fig. 19.

Fig. 19 is a flowchart illustrating an example of the gain calculating process according to the third embodiment. With respect to the steps illustrated in Fig. 19, the same or similar steps as those of Fig. 11 are referred to by the same numerals, and a description thereof will be omitted. Processes illustrated in Fig. 19 are performed by the gain calculating unit 127.

In step S40, the gain calculating unit 127 calculates a target power value by subtracting the target attenuation amount from the power value of the spectrum peak. In step S41, a check is made as to whether the spectrum power value of a frequency component of interest is a spectrum peak and no smaller than the target power value.

If the result of the check in step S41 is YES, attenuation amounts around the frequency component of interest are calculated in step S42 such that the resultant power values do not exceed the target power value and also form a gentle slope falling from the spectrum peak. If the result of the check in step S41 is NO, the procedure goes back to step S41. When attenuation amounts are calculated for all the frequency components, the gain calculating process comes to an end.

According to the third embodiment, spectrum peaks are attenuated in the frequency domain, thereby compressing the dynamic range of an input signal while avoiding the generation of dissonant sounds caused by spectrum amplification.

A target attenuation amount is determined for the power value of the spectrum peak. The attenuation amounts of respective frequency components are then determined such that the resultant power spectrum values do not exceed the target power value and also form gentle slopes falling from each spectrum peak. This allows the spectrum to be attenuated around the spectrum peak while avoiding audio quality degradation.

[Fourth Embodiment]

<Main Configuration>

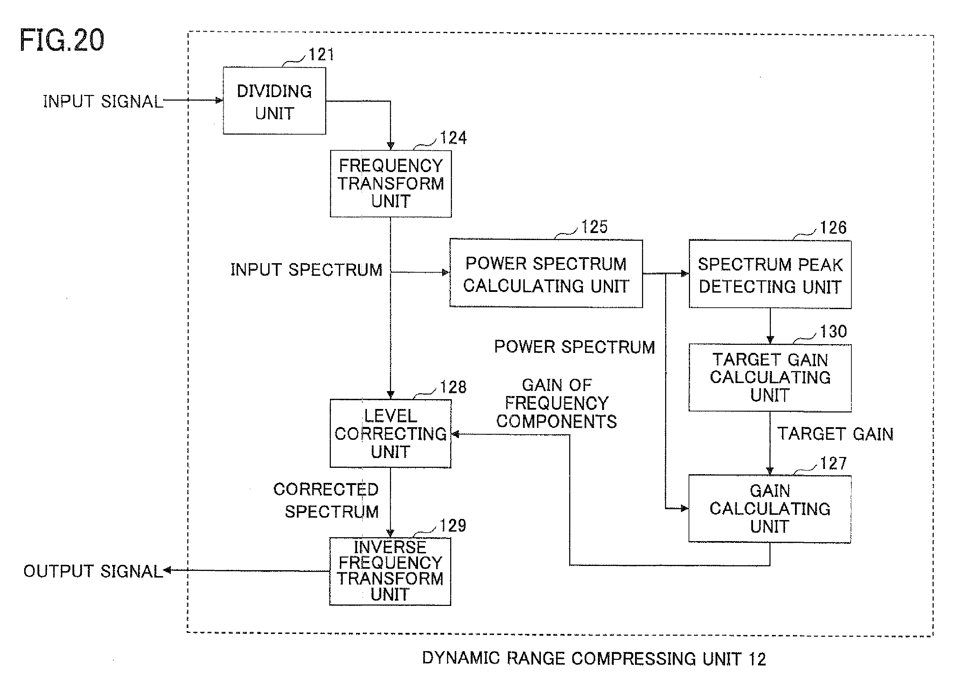

In the following, a sound processing apparatus according to a fourth embodiment will be described. The application field of the sound processing apparatus of the fourth embodiment may be one of the application fields of the first through third embodiments. Fig. 20 is a drawing illustrating an example of the configuration of the dynamic range compressing unit according to the fourth embodiment.

The fourth embodiment differs from the previously described embodiments in how the target attenuation amount is calculated. As illustrated in Fig. 20, a target gain calculating unit 130 subtracts a predetermined threshold value from the power value Amp_peak of the spectrum peak supplied from the spectrum peak detecting unit 126 to calculate a target attenuation amount. The predetermined threshold value is determined in advance in response to the characteristics of the speaker similarly to the manner in which the first threshold value is determined. Processes performed after the calculation of the target attenuation amount are the same as or similar to the previously described embodiments.

<Sound Processing>

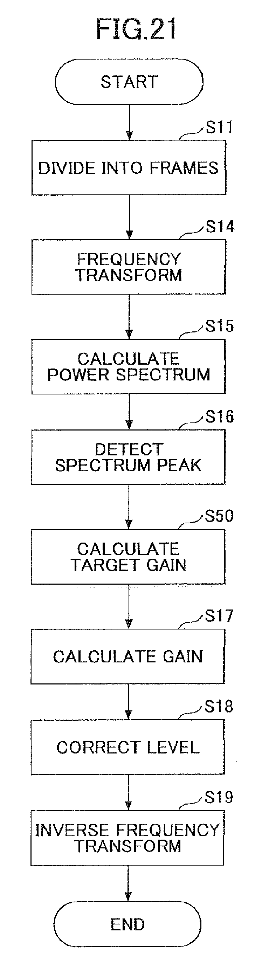

Fig. 21 is a drawing illustrating an example of sound processing according to the fourth embodiment. With respect to the processes illustrated in Fig. 21, the same or similar processes as those of Fig. 10 are referred to by the same numerals, and a description thereof will be omitted. The sound processing of the fourth embodiment differs from the sound processing of the previously described embodiments in that a target gain calculating process of step S50 is performed after the process of calculating a spectrum peak in step S16. As described above, the target gain calculating process calculates a target attenuation amount by subtracting a predetermined threshold value from the power value Amp_peak of the spectrum peak.

The gain calculating process of the fourth embodiment may be any one of the gain calculating processes used in the previously described embodiments. The fourth embodiment described above brings about advantages as desirable as those of the previously described embodiments by use of a simpler configuration. In the case where accurate sound volume control is desirable, one of the first through third embodiments may be used. In the case where a simpler configuration is preferred to achieve the objects, the fourth embodiment may be used.

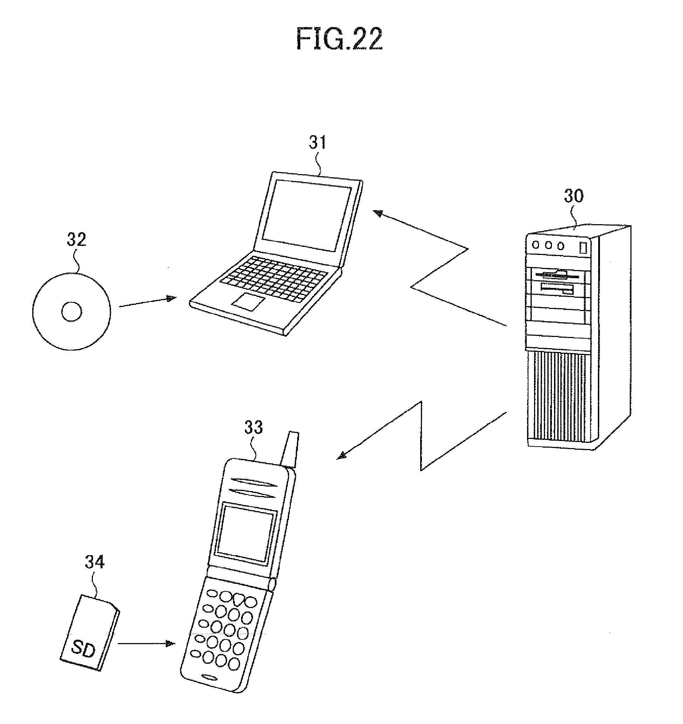

In the following, a description will be given of a variation of the embodiments described above. Fig. 22 is a drawing illustrating a variation of the application of disclosed sound processing. As illustrated in Fig. 22, the sound processing of the previously described embodiments may be implemented as a program for causing a computer 31 to perform the processing. Such a program may be installed from a server 30 or the like for execution by the computer 31, thereby performing the above-described sound processing.

This program may be recorded in a recording medium (e.g., CD-ROM 32, SD card 34, or the like). Such a recording medium having the program recorded therein may be read by the computer 31 or a portable terminal 33, thereby performing the sound processing as previously described. The recording medium may be any type of recording medium. That is, it may be a recording medium for recording information by use of an optical, electrical, or magnetic means such as a CD-ROM, a flexible disk, or a magneto-optical disk, or may be a semiconductor memory for recording information by use of an electrical means such as a ROM or a flash memory. The disclosed embodiments and variations thereof may be particularly effective for an apparatus provided with a small speaker such as a portable terminal or an IP phone.

According to at least one embodiment, a sound processing method that compresses a dynamic range while avoiding audio quality degradation is provided.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment(s) of the present inventions have been described in detail, it should be understood that the various changes, substitutions, and alterations could be made hereto without departing from the spirit and scope of the invention.

**Claims**

1. A sound processing method, comprising:

    transforming an input signal from a time domain to a frequency domain to produce a spectrum;
    detecting a peak of the spectrum;
    calculating a target attenuation amount based on one of the input signal and the spectrum;
    calculating attenuation amounts of respective frequency components of the spectrum based on the target attenuation amount and the detected peak;
    correcting levels of the spectrum by attenuating the spectrum in response to the calculated attenuation amounts of respective frequency components; and
    performing inverse frequency transform with respect to the level-corrected spectrum to produce an output signal.

2. The sound processing method as claimed in claim 1, wherein the step of calculating a target attenuation amount calculates the target attenuation amount based on one of a maximum amplitude of the input signal and a power spectrum value of the detected peak.

3. The sound processing method as claimed in claim 2, wherein the step of calculating attenuation amounts sets an attenuation amount of the peak to the target attenuation amount, and sets attenuation amounts of frequency components excluding the peak to smaller than the target attenuation amount.

4. The sound processing method as claimed in claim 3, wherein the step of calculating attenuation amounts determines an attenuation amount of a given frequency component other than the peak based on a difference between a power spectrum value of the peak and a power spectrum value of the given frequency component.

5. The sound processing method as claimed in claim 4, wherein the step of calculating attenuation amounts determines the attenuation amount of a given frequency component other than the peak for which said difference is smaller than a threshold value, such that the determined attenuation amount is smaller than the target attenuation amount by a value proportional to said difference.

6. The sound processing method as claimed in claim 5, wherein the step of calculating attenuation amounts sets to zero the attenuation amount of a given frequency component excluding the peak for which said difference is larger than the threshold value.

7. The sound processing method as claimed in claim 3, wherein the step of calculating attenuation amounts determines an attenuation amount of a given frequency component other than the peak based on a difference between a frequency of the peak and a frequency of the given frequency component.

8. The sound processing method as claimed in claim 7, wherein the step of calculating attenuation amounts determines an attenuation amount of a given frequency component other than the peak based on a difference between a frequency of a local maximum frequency component other than the peak and a frequency of the given frequency component.

9. The sound processing method as claimed in claim 7, wherein the step of calculating attenuation amounts determines the attenuation amount of a given frequency component other than the peak for which said difference is smaller than a threshold value, such that the determined attenuation amount is smaller than the target attenuation amount by a value proportional to said difference.

10. The sound processing method as claimed in claim 8, wherein the step of calculating attenuation amounts determines the attenuation amount of a given frequency component other than the local maximum frequency component for which said difference is smaller than a threshold value, such that the determined attenuation amount is smaller than the target attenuation amount by a value proportional to said difference.

11. The sound processing method as claimed in claim 9, wherein the step of calculating attenuation amounts sets to zero the attenuation amount of a given frequency component excluding the peak for which said difference is larger than the threshold value.

12. The sound processing method as claimed in claim 10, wherein the step of calculating attenuation amounts sets to zero the attenuation amount of a given frequency component excluding the local maximum frequency component for which said difference is larger than the threshold value.

13. The sound processing method as claimed in claim 3, wherein the step of calculating attenuation amounts calculates a target power spectrum value by reducing a power spectrum value of the peak by the target attenuation amount, and determines an attenuation amount of a given frequency component other than the peak such that a power spectrum value of the given frequency component becomes smaller than the target power spectrum value.

14. A computer-readable medium having a program embodied therein, said program causing a computer to perform:

   transforming an input signal from a time domain to a frequency domain to produce a spectrum;
   detecting a peak of the spectrum;
   calculating a target attenuation amount based on one of a maximum amplitude of the input signal and a power spectrum value of the detected peak;
   calculating attenuation amounts of respective frequency components of the spectrum based on the target attenuation amount and the detected peak;
   correcting levels of the spectrum by attenuating the spectrum in response to the calculated attenuation amounts of respective frequency components; and
   performing inverse frequency transform with respect to the level-corrected spectrum to produce an output signal.

15. A sound processing apparatus, comprising:

   a frequency transform unit configured to transform an input signal from a time domain to a frequency domain to produce a spectrum;
   a peak detecting unit configured to detect a peak of the spectrum;
   a target attenuation amount calculating unit configured to calculate a target attenuation amount based on one of a maximum amplitude of the input signal and a power spectrum value of the detected peak;
   an attenuation amount calculating unit configured to calculate attenuation amounts of respective frequency components of the spectrum based on the target attenuation amount and the detected peak;
   a level correcting unit configured to correct levels of the spectrum by attenuating the spectrum in response to the calculated attenuation amounts of respective frequency components; and
   an inverse frequency transform unit configured to perform inverse frequency transform with respect to the level-corrected spectrum to produce an output signal.

EP 2 200 340 A1

# FIG.1

INPUT SIGNAL → | DYNAMIC RANGE COMPRESSION UNIT (1) | → | D/A (2) | → (3) → (4) → PRODUCED SOUND

# FIG.2

# FIG.3

EP 2 200 340 A1

# FIG.4

EP 2 200 340 A1

# FIG.5

RECEIVED PACKET → | PACKET RECEIVING UNIT | 10 → | DECODING UNIT | 11 → | DYNAMIC RANGE COMPRESSING UNIT | 12 → | AMPLIFIER | 13 → SPEAKER 14

EP 2 200 340 A1

# FIG.6

DYNAMIC RANGE COMPRESSING UNIT 12

INPUT SIGNAL → 121 DIVIDING UNIT

122 MAXIMUM AMPLITUDE DETECTING UNIT

123 TARGET-GAIN CALCULATING UNIT

MAXIMUM AMPLITUDE

TARGET GAIN

124 FREQUENCY TRANSFORM UNIT

125 POWER SPECTRUM CALCULATING UNIT

126 SPECTRUM PEAK DETECTING UNIT

127 GAIN CALCULATING UNIT

INPUT SPECTRUM

POWER SPECTRUM

GAIN OF FREQUENCY COMPONENTS

128 LEVEL CORRECTING UNIT

CORRECTED SPECTRUM

129 INVERSE FREQUENCY TRANSFORM UNIT

OUTPUT SIGNAL

FIG.7

EP 2 200 340 A1

# FIG.8

FIG.9

GAIN

G_target

f_peak

FREQUENCY

EP 2 200 340 A1

# FIG.10

```
        ┌──────────┐
        │  START   │
        └────┬─────┘
             │               S11
        ┌────▼─────────┐
        │ DIVIDE INTO  │
        │   FRAMES     │
        └────┬─────────┘
             │
             │────────────────────────────┐
             │                             │        S14
             │                        ┌────▼─────────┐
             │               S12      │ FREQUENCY    │
        ┌────▼─────────┐              │ TRANSFORM    │
        │DETECT MAXIMUM│              └────┬─────────┘
        │  AMPLITUDE   │                   │        S15
        └────┬─────────┘              ┌────▼─────────┐
             │               S13      │  CALCULATE   │
        ┌────▼─────────┐              │POWER SPECTRUM│
        │  CALCULATE   │              └────┬─────────┘
        │ TARGET GAIN  │                   │        S16
        └────┬─────────┘              ┌────▼─────────┐
             │                        │   DETECT     │
             │                        │SPECTRUM PEAK │
             │                        └────┬─────────┘
             │◄────────────────────────────┘
             │               S17
        ┌────▼─────────┐
        │CALCULATE GAIN│
        └────┬─────────┘
             │               S18
        ┌────▼─────────┐
        │CORRECT LEVEL │
        └────┬─────────┘
             │               S19
        ┌────▼─────────┐
        │   INVERSE    │
        │  FREQUENCY   │
        │  TRANSFORM   │
        └────┬─────────┘
             │
        ┌────▼─────┐
        │   END    │
        └──────────┘
```

# FIG.11

GAIN CALCULATING
PROCESS START

↓

S20

OBTAIN DIFFERENCE BETWEEN
PEAK POWER VALUE AND
POWER VALUE OF INTEREST

↓

S21

OBTAINED
DIFFERENCE
SMALLER THAN OR EQUAL
TO THRESHOLD
VALUE?

— NO →

YES ↓

S22

CALCULATE
ATTENUATION AMOUNT

S23

ATTENUATION
AMOUNT = 0

↓

S24

ATTENUATION
AMOUNT CALCULATED
FOR ALL FREQUENCY
COMPONENTS
?

← NO

YES ↓

GAIN CALCULATING
PROCESS END

# FIG.12

RECEIVED SIGNAL ─────→ DECODING UNIT /20 ──→ DYNAMIC RANGE COMPRESSING UNIT /21 ──→ AMPLIFIER /13 ──→ SPEAKER /14

EP 2 200 340 A1

# FIG.13

FIG.14

POWER

INPUT SPECTRUM

G_target

f_peak

LEVEL-CORRECTED SPECTRUM

FREQUENCY

EP 2 200 340 A1

EP 2 200 340 A1

# FIG.15

# FIG.16

GAIN CALCULATING
PROCESS START

S30
OBTAIN DIFFERENCE BETWEEN
PEAK FREQUENCY AND
FREQUENCY OF INTEREST

S31
OBTAINED
DIFFERENCE FALLS
WITHIN PREDETERMINED
RANGE?

NO

YES

S32
CALCULATE
ATTENUATION AMOUNT

S33
ATTENUATION
AMOUNT = 0

S34
ATTENUATION
AMOUNT CALCULATED
FOR ALL FREQUENCY
COMPONENTS
?

NO

YES

GAIN CALCULATING
PROCESS END

# FIG.17

POWER

G_target

INPUT SPECTRUM

Amp_target

f_peak

FREQUENCY

LEVEL-CORRECTED SPECTRUM

EP 2 200 340 A1

FIG.18

# FIG.19

GAIN CALCULATING
PROCESS START

S40

CALCULATE TARGET
POWER VALUE

S41

POWER
VALUE OF
INTEREST IS SPECTRUM
PEAK LARGER THAN THE
TARGET POWER
VALUE
?

NO

YES

S42

CALCULATE
ATTENUATION AMOUNT

S43

ATTENUATION
AMOUNT CALCULATED
FOR ALL FREQUENCY
COMPONENTS
?

NO

YES

GAIN CALCULATING
PROCESS END

# FIG.20

INPUT SIGNAL

121 DIVIDING UNIT

124 FREQUENCY TRANSFORM UNIT

INPUT SPECTRUM

125 POWER SPECTRUM CALCULATING UNIT

POWER SPECTRUM

126 SPECTRUM PEAK DETECTING UNIT

130 TARGET GAIN CALCULATING UNIT

TARGET GAIN

127 GAIN CALCULATING UNIT

GAIN OF FREQUENCY COMPONENTS

128 LEVEL CORRECTING UNIT

CORRECTED SPECTRUM

129 INVERSE FREQUENCY TRANSFORM UNIT

OUTPUT SIGNAL

DYNAMIC RANGE COMPRESSING UNIT 12

# FIG.21

```
        ┌─────────────┐
        │    START    │
        └──────┬──────┘
               │        S11
        ┌──────▼──────────┐
        │ DIVIDE INTO FRAMES │
        └──────┬──────────┘
               │        S14
        ┌──────▼──────┐
        │  FREQUENCY  │
        │  TRANSFORM  │
        └──────┬──────┘
               │        S15
        ┌──────▼──────┐
        │  CALCULATE  │
        │POWER SPECTRUM│
        └──────┬──────┘
               │        S16
        ┌──────▼──────┐
        │    DETECT    │
        │SPECTRUM PEAK│
        └──────┬──────┘
               │        S50
        ┌──────▼──────┐
        │  CALCULATE  │
        │ TARGET GAIN │
        └──────┬──────┘
               │        S17
        ┌──────▼──────┐
        │CALCULATE GAIN│
        └──────┬──────┘
               │        S18
        ┌──────▼──────┐
        │CORRECT LEVEL │
        └──────┬──────┘
               │        S19
        ┌──────▼────────┐
        │INVERSE FREQUENCY│
        │   TRANSFORM    │
        └──────┬────────┘
               │
        ┌──────▼──────┐
        │     END     │
        └─────────────┘
```

# FIG.22

EP 2 200 340 A1

Europäisches Patentamt
European Patent Office
Office européen des brevets

# EUROPEAN SEARCH REPORT

Application Number

EP 09 17 6311

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/245604 A1 (SPIELBAUER GEORG [DE] ET AL) 2 November 2006 (2006-11-02)<br>* paragraph [0001] - paragraph [0003] *<br>* paragraph [0008] - paragraph [0013] *<br>* paragraph [0021] - paragraph [0028]; figure 1 * | 1-15 | INV.<br>H04R3/04<br>H03G9/02<br>H03G7/00 |
| A | US 7 013 011 B1 (WEEKS WILLIAM A [US] ET AL) 14 March 2006 (2006-03-14)<br>* figures 8,9 *<br>* paragraph [0006] - paragraph [0007] *<br>* paragraph [0011] - paragraph [0012] *<br>* paragraph [0016] *<br>* paragraph [0046] *<br>* paragraph [0056] - paragraph [0059] *<br>* paragraph [0004] * | 2 | |
| A | US 2008/123883 A1 (BLAMEY PETER JOHN [AU] ET AL) 29 May 2008 (2008-05-29)<br>* paragraph [0011] - paragraph [0012] *<br>* paragraph [0095] - paragraph [0101]; figure 5 *<br>* claim 40 * | 1-15 | TECHNICAL FIELDS SEARCHED (IPC)<br>H04R<br>H03G<br>G10L |
| A | US 2007/286428 A1 (LUO HENRY [CA]) 13 December 2007 (2007-12-13)<br>* paragraph [0003] - paragraph [0004] *<br>* paragraph [0048] - paragraph [0051] *<br>* paragraph [0079] - paragraph [0081] * | 1-15 | |

The present search report has been drawn up for all claims

| Place of search | Date of completion of the search | Examiner |
|---|---|---|
| Munich | 18 March 2010 | Guillaume, Mathieu |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

34

**ANNEX TO THE EUROPEAN SEARCH REPORT
ON EUROPEAN PATENT APPLICATION NO.**

EP 09 17 6311

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2010

| Patent document cited in search report | | Publication date | Patent family member(s) | | Publication date |
|---|---|---|---|---|---|
| US 2006245604 | A1 | 02-11-2006 | DE 10232645 A1<br>WO 2004010412 A2<br>EP 1523805 A2 | | 05-02-2004<br>29-01-2004<br>20-04-2005 |
| US 7013011 | B1 | 14-03-2006 | US 7242783 B1 | | 10-07-2007 |
| US 2008123883 | A1 | 29-05-2008 | NONE | | |
| US 2007286428 | A1 | 13-12-2007 | NONE | | |

EPO FORM P0459